# EUROPEAN PATENT APPLICATION

(11) **EP 3 128 819 A1**
(43) Date of publication of application: **08.02.2017**
(21) Application number: 14887912.5
(22) Date of filing: 31.03.2014
(51) Int. Cl.: H05H 1/46, H01L 21/205, H01L 21/3065

(54) **PLASMA TREATMENT DEVICE AND COIL USED THEREIN**

(71) Applicant: SPP Technologies Co., Ltd., Tokyo 100-0004 (JP)
(72) Inventor: HAYAMI, Toshihiro, Amagasaki-shi Hyogo 660-0891 (JP); MIYAZAKI, Toshiya, Amagasaki-shi Hyogo 660-0891 (JP)
(74) Representative: Isarpatent
(86) International application number: PCT/JP2014/059432
(87) International publication number: WO 2015/151150

(57) **Abstract**

A plasma etching apparatus includes a chamber having a processing space and a plasma generating space 4 defined therein and a coil 20 wound around the processing chamber, the coil 20 has at least three inward projecting portions 21 formed thereon which project inward in a radial direction with respect to a pitch circle P defined outside a portion of the processing chamber 2 corresponding to the plasma generating space 4, and the at least three inward projecting portions 21 are arranged at equal intervals along a circumferential direction of the pitch circle P.

## Description

### Technical Field

0001 The present invention relates to a plasma processing apparatus that supplies a predetermined processing gas into a processing chamber, generates plasma from the processing gas, and performs a plasma processing on a substrate in the processing chamber by the plasma generated from the processing gas and to a coil used in the plasma processing apparatus, and particularly relates to a plasma processing apparatus that symmetrically generates plasma from a processing gas in a plasma generating space and to a coil used in the plasma processing apparatus.

### Background Art

0002 Examples of the above-mentioned plasma processing include a plasma etching processing in which a substrate (a silicon substrate, a silicon carbide substrate, or the like) is etched by ions and radicals contained in plasma generated from a processing gas, and a plasma CVD processing in which a thin film is formed on a substrate. Further, various apparatuses have been suggested as an apparatus used for performing such a processing, and the applicant of the present application also has suggested an inductively coupled plasma etching apparatus used for performing a plasma etching processing on, for example, a silicon substrate (Japanese Unexamined Patent Application Publication No. 2010-238847).

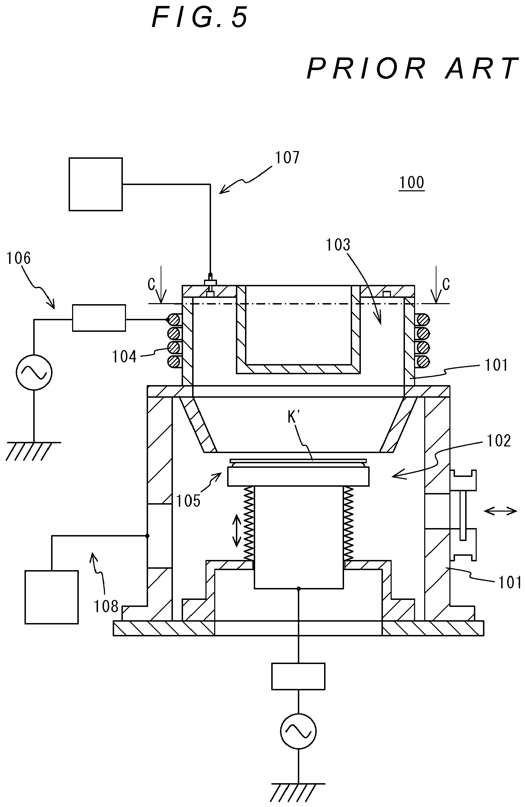

0003 As shown in Fig. 5, the above-mentioned plasma etching apparatus 100 includes a cylindrical processing chamber 101 having a processing space 102 defined in a lower region of its interior and a plasma generating space 103, which communicates with the processing space 102, defined above the processing space 102 in its interior, a coil 104 disposed outside a portion of the processing chamber 101 where the plasma generating space 103 is defined, a platen 105 disposed in the processing space 102, a coil power supply mechanism 106 for supplying RF power to the coil 104, a processing gas supply mechanism 107 for supplying a processing gas, e.g., an etching gas or a passivation-film forming gas, into the plasma generating space 103, an exhaust mechanism 108 for exhausting gas in the processing chamber 101, and other components. This plasma etching apparatus 100 is configured to produce an induced electric field by supplying RF power having predetermined frequency and power to the coil 104, supply a processing gas into the plasma generating space 103 and generate plasma from the processing gas by the induced electric field, and perform an etching processing on a surface of a substrate K' by the plasma generated from the processing gas.

### Citation List

### Patent Literature

0004 *Patent Literature1:* Japanese Unexamined Patent Application Publication No. 2010-238847

### Summary of Invention

### Technical Problem

0005 By the way, in an etching processing using the plasma etching apparatus 100, in order to improve the yield, it is preferred that the etching processing is performed as uniformly as possible over the entire surface of the substrate K'. In order to realize this, it is necessary to generate plasma uniformly from a processing gas in the plasma generating space 103 so that the plasma generated from the processing gas acts uniformly over the entire surface of the substrate K'.

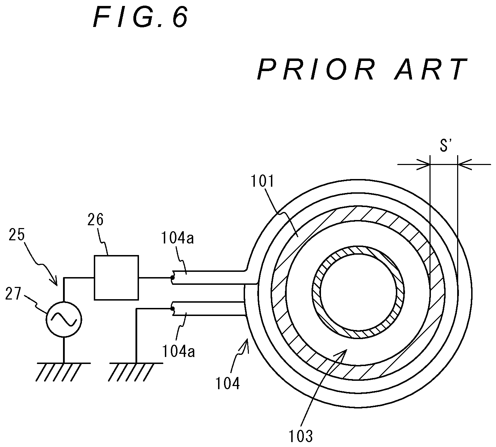

0006 The inventors intensively studied to generate plasma uniformly from a processing gas in the plasma generating space 103. As a result, they found out that density distribution of plasma generated in the plasma generating space 103 depended on the distance S' between the coil 104 and the plasma generating space 103 (see Fig. 6), and found out that the plasma density distribution in the plasma generating space 103 was more likely to become non-uniform if there was a portion where the distance S' was different, even if slightly. Uniformity of etching can be an issue especially in deep silicon etching for MEMS (Micro Electro Mechanical Systems) that requires highly accurate vertical processing.

0007 It is conceivable that the reason why the presence of a portion where the distance S' is different, even if slightly, causes plasma generated in the plasma generating space 103 to have a non-uniform density distribution is as follows.

0008 In the plasma generating space 103, once plasma is generated, a current flows in the plasma and an electric power caused by the current is absorbed by the plasma, and therefore the generation of plasma from the processing gas proceeds and the plasma density is increased. When the plasma density is increased, in other words, when the numbers of electrons and ions in the plasma are increased, electrical resistance of the plasma is reduced and the amount of the electric power absorbed by the plasma is increased, and therefore the generation of plasma proceeds and the plasma density is further increased. That is, once plasma is generated in the plasma generating space 103, the generation of plasma from the processing gas proceeds at an increasing rate.

0009 Therefore, because an induced magnetic field acting on the processing gas is stronger when the distance S' between the coil 104 and the plasma generating space 103 is smaller, it is conceivable that, if a portion of the distance S' is smaller, even if slightly, plasma is generated at an increasing rate at the smaller distance S portion in advance of the generation of plasma at other portions, and consequently the plasma generated in the plasma generating space 103 has a non-uniform density distribution.

0010 Further, although the distance S' between the coil 104 and the plasma generating space 103 depends on the dimensions of the coil 104 and the processing chamber 101, it is very difficult to make the distance S' strictly uniform by improving the accuracy of dimension throughout their circumferences. Further, the coil 104 must have two power introducing portions 104a and 104b, one of which is connected to the coil power supply mechanism 106 and the other of which is connected to an earth, and a gap is provided between the two power introducing portions 104a and 104b. Therefore, a portion of the plasma generating space 103 corresponding to the gap between the two power introducing portions 104a and 104b is necessarily a singularity at which the induced electric field is weak. Because of the foregoing problems, it is very difficult to generate plasma uniformly from a processing gas in the plasma generating space 103. In particular, in an apparatus which performs a plasma processing on a small-diameter substrate (for example, a substrate having a diameter equal to or smaller than 1 inch), if the size of the apparatus is designed in accordance with the diameter of the substrate, the size of the coil is necessarily smaller and the gap between the power introducing portions is relatively large with respect to the size of the whole coil, which makes it more difficult to generate plasma uniformly from a processing gas.

0011 Therefore, the inventors further studied, and consequently they found out that, when plasma is generated intentionally so that high density portions were axially symmetrical in the plasma generating space 103, the generated plasma diffused uniformly and thereby in-plane density of the plasma was uniformized before the generated plasma reached the substrate K', and therefore the plasma was eventually able to act uniformly on the substrate K'.

0012 The present invention has been achieved based on the above-mentioned new findings, and an object thereof is to provide a plasma processing apparatus capable of generating plasma from a processing gas in a plasma generating space so that high plasma density portions in the plasma generating space are axially symmetrical, and a coil used in the plasma processing apparatus.

### Solution to Problem

0013 The present invention, for solving the above-described problems, includes a plasma processing apparatus configured to supply a processing gas into a plasma generating space defined in a processing chamber, generate plasma from the processing gas in the plasma generating space by supplying RF power from a coil power supply mechanism to an annular coil wound outside a portion of the processing chamber corresponding to the plasma generating space, and perform a plasma processing on a substrate placed on a platen by the plasma generated from the processing gas,
the coil having
two power introducing portions having a gap between them, one of the power introducing portions being connected to the coil power supply mechanism and the other being connected to an earth, and
at least three inward projecting portions projecting inward in a radial direction with respect to a reference circle defined around the processing chamber corresponding to the plasma generating space, the at least three inward projecting portions being formed at equal intervals along a circumferential direction of the reference circle.

0014 According to the plasma processing apparatus of the present invention, first, a substrate is placed on the platen, and then a processing gas is supplied into the plasma generating space and RF power is supplied to the coil.

0015 Note that, in the plasma processing apparatus of the present invention, since the coil has at least three inward projecting portions formed thereon, the distance between the processing chamber and the inward projecting portions of the coil is smaller than the distance between the processing chamber and portions of the coil other than the inward projecting portions. Therefore, when RF power is supplied to the coil, an induced electric field acting on portions of the plasma generating space corresponding to the inward projecting portions is stronger than an induced electric field acting on portions of the plasma generating space corresponding to the portions of the coil other than the inward projecting portions, and therefore, at the portions corresponding to the inward projecting portions, the generation of plasma from the processing gas easily proceeds and plasma density is increased. Further, the at least three inward projecting portions formed at equal intervals along the circumferential direction of the reference circle brings about a state where high plasma density portions are arranged at equal intervals along the circumferential direction, in other words, axially symmetrically arranged, in the plasma generating space. Note that the arrangement in which the at least three inward projecting portions are formed at equal intervals along the circumferential direction of the reference circle is a concept which, as a matter of course, includes an arrangement in which the at least three inward projecting portions having an equal distance and an equal angle with respect to the center of the plasma generating space are symmetrically formed; the arrangement in which the at least three inward projecting portions having an equal distance and an equal angle with respect to the center of the plasma generating space are symmetrically formed also brings about the state where high plasma density portions are axially symmetrically arranged.

0016 Thus, when the inward projecting portions that are close to the processing chamber are intentionally provided on the coil so as to generate plasma from a processing gas in the plasma generating space so that high plasma density portions are axially symmetrically arranged, a low plasma density portion that corresponds to the above-mentioned singularity can be mostly ignored, and the generated plasma diffuses from the high plasma density portions to portions having a relatively lower plasma density than the high plasma density portions and thereby in-plane density of the plasma is uniformized before the generated plasma reaches the substrate. Therefore, the plasma is eventually able to act uniformly on the substrate.

0017 Note that it is preferred that the coil in the plasma processing apparatus has at least two outward projecting portions formed thereon along the circumferential direction of the reference circle, which project outward in the radial direction with respect to the reference circle, and the at least two outward projecting portions, the at least three inward projecting portions, and the gap between the power introducing portions are arranged at equal intervals along the circumferential direction.

0018 In this case, the distance between the processing chamber and the outward projecting portions of the coil and the distance between the processing chamber and the gap between the power introducing portions of the coil are long, and therefore induced electric fields acting on portions of the plasma generating space corresponding to the at least two outward projecting portions and to the gap between the power introducing portions are weak, which brings about a state where low plasma density portions are arranged at equal intervals along the circumferential direction, that is, axially symmetrically arranged. Accordingly, the high plasma density portions and the low plasma density portions are alternately arranged, and therefore the plasma diffuses more smoothly from the high plasma density portions to the low plasma density portions, which promotes the uniformization of the plasma density. Note that the state where the at least two outward projecting portions and the gap between the power introducing portions are arranged at equal intervals along the circumferential direction of the reference circle, as a matter of course, includes a state where they are symmetrically arranged at an equal distance and an equal angle with respect to the center of the plasma generating space; the arrangement in which the at least two outward projecting portions and the gap between the power introducing portions having an equal distance and an equal angle with respect to the center of the plasma generating space are symmetrically formed also brings about the state where low plasma density portions are axially symmetrically arranged.

0019 Further, the coil in the plasma processing apparatus of the present invention is capable of producing high plasma density portions and promoting uniform diffusion of plasma from the high plasma density portions to low plasma density portions even when it has a single turn. Further, since the coil has the inward projecting portions and the outward projecting portions formed thereon which respectively project inward and outward in the radial direction of the reference circle, or has the inward projecting portions and the outward projecting portions formed thereon which have an equal distance and an equal angle with respect to the center of the plasma generating space, it is possible to make the thickness in the height direction of the coil uniform along the circumferential direction and thereby make the coil compact. Therefore, the coil can be particularly suitably used in a small-sized plasma processing apparatus which is limited in height, such as a plasma processing apparatus processing a substrate having a diameter equal to or smaller than 1 inch.

0020 Note that, in the case where the coil has two or more turns, the coil can have a transition portion formed thereon, at which, for example, the first wound portion changes to the second wound portion or the second wound portion changes to the third wound portion. Such a transition portion is a singular portion on the coil; therefore, in the case where the coil has such a transition portion formed thereon, there is a possibility that an induced electric field from the transition portion of the coil acts on only a part of a portion of the plasma generating space corresponding to between wound portions of the coil.

0021 Therefore, in the case where the coil has two or more turns in the plasma processing apparatus, it is preferred that the coil has a transition portion from a wound portion to a next wound portion formed thereon near the gap between the power introducing portions and the transition portion projects outward in the radial direction with respect to the reference circle.

0022 Thus, when a transition portion having a shape projecting outward in the radial direction with respect to the reference circle is formed on the coil, it is possible to make an induced electric field acting on a portion of the plasma generating space corresponding to the transition portion as weak as possible and thereby diminish the influence on the generation of plasma from a processing gas, which prevents a problem that the balance of the plasma density in the plasma generating space is lost because the plasma density is unexpectedly increased at only a part of a portion of the plasma generating space corresponding to between wound portions of the coil.

0023 Note that examples of the "substrate" used in the application include substrates made of silicon, silicon carbide, sapphire, compound semiconductor, glass, and resin.

### Advantageous Effects of Invention

0024 As described above, according to the plasma processing apparatus of the present invention, it is possible to generate plasma from a processing gas in the plasma generating space so that high plasma density portions in the plasma generating space are axially symmetrical.

### Brief Description of Drawings

0025
Fig. 1 is a front sectional view showing a plasma processing apparatus according to an embodiment of the present invention;
Fig. 2 is an enlarged sectional view taken along A-A in Fig. 1;
Fig. 3 is a sectional view showing a plasma processing apparatus according to another embodiment of the present invention;
Fig. 4(a) is a top view showing a coil in the plasma processing apparatus according to the another embodiment of the present invention, and Fig. 4(b) is a view as viewed in the arrow B direction in Fig. 4(a);
Fig. 5 is a front sectional view showing a conventional plasma etching apparatus; and
Fig. 6 is an enlarged sectional view taken along C-C in Fig. 6.

### Description of Embodiments

0026 Hereinafter, a specific embodiment of the present invention will be described based on the drawings. Note that the plasma processing apparatus of the embodiment is a plasma etching apparatus, which performs a plasma etching processing on a substrate.

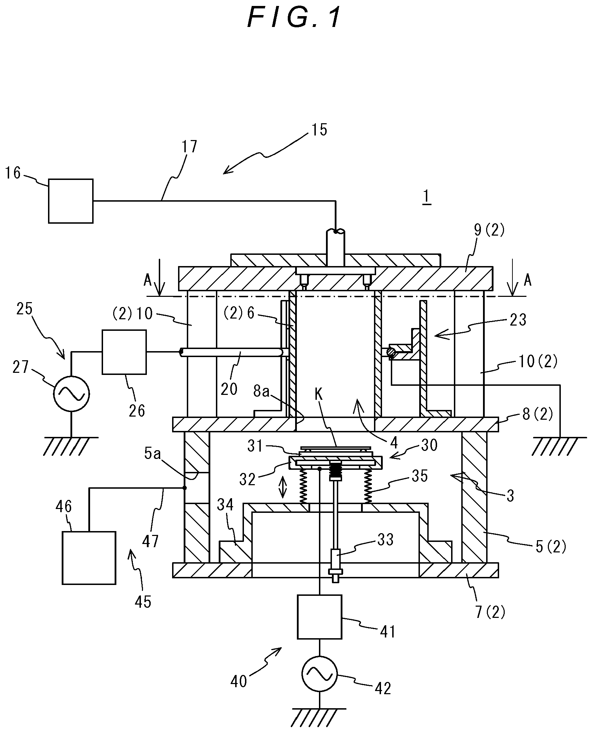

0027 As shown in Fig. 1, a plasma etching apparatus 1 of this embodiment includes a cylindrical processing chamber 2 having a processing space 3 defined in a lower portion of its inner space and a plasma generating space 4 defined above the processing space 3 in its inner space, a processing gas supply mechanism 15 for supplying a processing gas into the plasma generating space 4, a coil 20 wound to surround the outer peripheral surface of a portion of the plasma processing chamber 2 where the plasma generating space 4 is defined, a coil power supply mechanism 25 for supplying RF power to the coil 20, a platen 30 disposed in the processing space 3 for placing a substrate K thereon, a platen power supply mechanism 40 for supplying RF power to the platen 30, and an exhaust device 45 exhausting gas in the processing chamber 2.

0028 The processing chamber 2 is composed of a lower body portion 5, an upper body portion 6, a bottom plate 7, an intermediate plate 8, a top plate 9, and support posts 10. The lower body portion 5 has a lower end to which the bottom plate 7 is fixed and an upper end to which the intermediate plate 8 is fixed, and the lower body portion 5, the bottom plate 7, and the intermediate plate 8 form the processing space 3. Further, the upper body portion 6 has a lower end fixed to the upper surface of the intermediate plate 8 and an upper end to which the top plate 9 is fixed, and the upper body portion 6, the intermediate plate 8, and the top plate 9 form the plasma generating space 4. Note that the intermediate plate 8 has an opening 8a formed therein and the processing space 3 and the plasma generating space 4 communicate with each other through the opening 8a. Further, a plurality of support posts 10 are provided between the intermediate plate 8 and the top plate 9.

0029 The upper body portion 6 is made of quartz, etc. and is formed so that its inner diameter (in other words, the outer diameter of the plasma generating space) is not less than 15 mm and not more than 50 mm, which is appropriate for a substrate K having a diameter equal to or smaller than 1 inch.

0030 The lower body portion 6 has an exhaust port 5a formed therein for exhausting gas in the processing space 3, and the exhaust port 5a is connected to the exhaust device 45 and gas in the processing chamber 2 is exhausted by the exhaust device 45.

0031 The processing gas supply mechanism 15 includes an etching gas supply unit 16 supplying an etching gas, e.g., SF₆ gas, and a supply pipe 17 having one end connected to a plurality of discharge ports provided in a circularly arranged manner in the lower surface of the top plate 9 and the other end connected to the etching gas supply unit 16, and the processing gas supply mechanism 15 supplies the etching gas from the etching gas supply unit 16 into the plasma generating space 4 through the supply pipe 17. Note that the etching gas is not limited to SF₆ gas and another fluorine-containing gas, e.g., CF₄, NF₃, or IF₅, can be used as the etching gas.

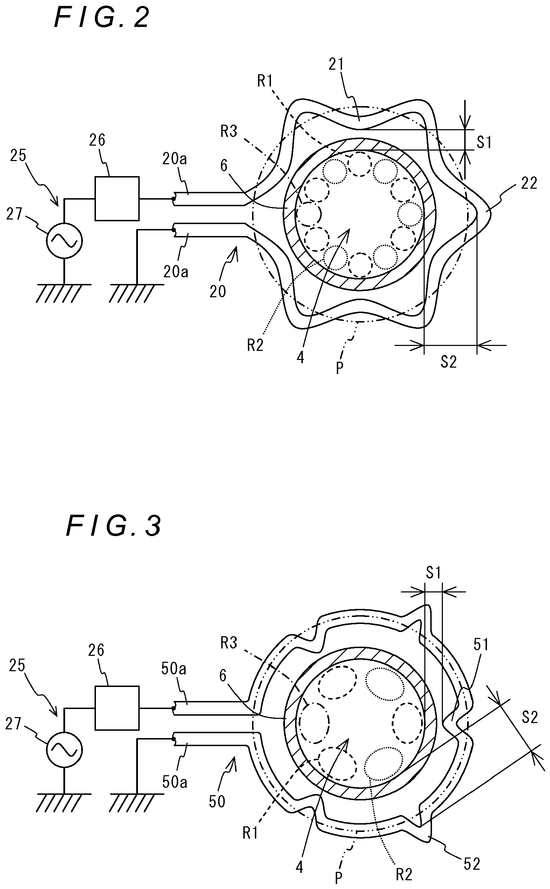

0032 As shown in Fig. 2, the coil 20 is wound outside the upper body portion 6 in such a manner that it surrounds the outer peripheral surface of the upper body portion 6. Further, the coil 20 has a power introducing portion 20a formed at one end thereof, which is extended outward in the radial direction, and a power introducing portion 20b formed at the other end thereof, which is also extended outward in the radial direction; the power introducing portion 20a is connected to the coil power supply mechanism 25, which is described later, and the power introducing portion 20b is connected to an earth. Note that the two power introducing portions 20a and 20b are respectively extended outward from positions facing each other and a gap is formed between them. Note that the coil 20 in the plasma etching apparatus 1 of this embodiment has a single turn and has a shape which is singly wound in one plane; therefore, it is possible to make the coil 20 compact and it is possible to align the direction of magnetic field so as to generate uniform plasma.

0033 Further, the coil 20 has six inward projecting portions 21 and five outward projecting portions 22 consecutively formed thereon, the inward projecting portions 21 project in a bent or curved manner inward in the radial direction with respect to a reference circle (hereinafter, referred to as "pitch circle") P defined outside the portion of the processing chamber 2 corresponding to the plasma generating space 4, and the outward projecting portions 22 project in a bent or curved manner outward in the radial direction with respect to the pitch circle P. The six inward projecting portions 21, and the five outward projecting portions 22 and the gap between the two power introducing portions 20a and 20b are alternately arranged at equal intervals along the circumferential direction of the pitch circle P. In other words, the six inward projecting portions 21 and the five outward projecting portions 22 which have an equal distance and an equal angle with respect to the center of the upper body portion 6 (the center of the plasma generating space 4) are alternately symmetrically arranged. Note that the coil 20 is being supported by a plurality of support members 23 attached on the upper surface of the intermediate plate 8 so that it is located approximately at the middle of the upper body portion 6.

0034 The coil power supply mechanism 25 is composed of an impedance matching device 26 connected to the power introducing portion 20a of the coil 20 and an RF power supply unit 27 connected to the impedance matching device 26, and, as described above, supplies RF power to the coil 20.

0035 The platen 30 is composed of an upper member 31 on which a substrate K is to be placed, and a lower member 32 to which a lifting cylinder 33 is connected. The platen 30 is disposed in the processing space 3 in a state of being supported by a support base 34 to be movable in upward and downward directions, and is configured to be moved upward and downward by the lifting cylinder 33. Note that bellows 35 covers between a peripheral edge portion of the lower surface of the lower member 32 and the top surface of the support base 34, by which airtightness of the processing space 3 is maintained.

0036 The platen power supply mechanism 40 is composed of an impedance matching device 41 connected to the platen 30 and an RF power supply unit 42 connected to the impedance matching device 41, and supplies RF power to the platen 30.

0037 The exhaust device 45 is composed of a vacuum pump 46 exhausting gas, and an exhaust pipe 47 having one end connected to the vacuum pump 46 and the other end connected to the exhaust port 5a of the lower body portion 5. The exhaust device 45 exhausts gas in the processing chamber 2 through the exhaust pipe 47 with the vacuum pump 46 to maintain the pressure in the processing chamber 2 at a predetermined pressure.

0038 Next, the process for performing an etching processing on a substrate K (for example, a silicon substrate) with the plasma etching apparatus 1 having the above-described configuration is described.

0039 First, a substrate K having a mask with a predetermined pattern formed on a surface thereof is placed on the platen 30 which is positioned at a lowered position. Subsequently, the platen 30 is moved upward to a processing position by the lifting cylinder 33, and then gas in the processing chamber 2 (the processing space 3 and the plasma generating space 4) is exhausted by the exhaust device 45 to adjust the pressure in the processing chamber 2 to a negative pressure.

0040 Further, simultaneously, an induced electric field is produced in the plasma generating space 4 by supplying RF power to the coil 20 from the RF power supply unit 27, and, under this condition, an etching gas is supplied into the plasma generating space 4 from the etching gas supply unit 16. Note that it is preferred that the RF power supplied to the coil 20 has a frequency equal to or greater than 100 kHz and a power equal to or less than 50 W.

0041 Note that the coil 20 in the plasma etching apparatus 1 of this embodiment has the inward projecting portions 21 and the outward projecting portions 22 formed thereon and the inward projecting portions 21, and the outward projecting portions 22 and the gap between the power introducing portions 20a and 20b are alternately arranged. The distance S1 from each of the inward projecting portions 21 to the plasma generating space 4 is smaller than the distance S2 from each of the outward projecting portions 22 to the plasma generating space 4; therefore, the induced electric field acting on portions of the plasma generating space 4 corresponding to the inward projecting portions 21 (the portions R1 surrounded by the dashed lines in Fig. 2) is stronger than the induced electric field acting on portions of the plasma generating space 4 corresponding to the outward projecting portions 22 (the portions R2 surrounded by the dotted lines in Fig. 2). Further, since there is the gap between the two power introducing portions 20a and 20b and the coil 20 is not present at the gap, the induced electric field acting on the portions corresponding to the inward projecting portions 22 is stronger than the induced electric field acting on a portion corresponding to the gap between the power introducing portions 20a and 20b (the portion R3 surrounded by the dotted-dashed line in Fig. 2). Accordingly, in the plasma generating space 4, plasma is more easily generated at the portions corresponding to the inward projecting portions 21 than at the portions corresponding to the outward projecting portions 22 and the portion corresponding to the gap between the power introducing portions 20a and 20b.

0042 Therefore, in the plasma etching apparatus 1 of this embodiment, the plasma density at the portions corresponding to the inward projecting portions 21 is relatively higher, while the plasma density at the portions corresponding to the outward projecting portions 22 and the portion corresponding to the gap between the power introducing portions 20a and 20b is relatively lower, which leads to a state where high plasma density portions and low plasma density portions are alternately arranged at equal intervals along the circumferential direction, in other words, a state where high plasma density portions are axially symmetrically arranged.

0043 Thereafter, RF power is supplied to the platen 30 from the RF power supply unit 42. Then, when the plasma generated from the etching gas in a state where high density portions and low density portions are alternately arranged at equal intervals flows downward into the processing space 3 though the opening 8a of the intermediate plate 8, the plasma diffuses smoothly from the high density portions to the low density portions. Therefore, the plasma generated from the etching gas reaches the substrate K after its in-plane density has been uniformized, and the plasma acts uniformly over the entire surface of the substrate K. Thereby, the surface of the substrate K is etched and an etching structure is formed in the surface of the substrate K. Note that, in the etching step in this embodiment, because a bias potential is applied to the substrate K by supplying RF power to the platen 30, ions in the plasma are irradiated onto the substrate K and the so-called ion-assisted etching is performed.

0044 As described above, according to the plasma etching apparatus 1 of this embodiment, smooth diffusion of plasma is achieved by producing a state where high plasma density portions and low plasma density portions are alternately arranged at equal intervals, in other words, high plasma density portions and low plasma density portions are each axially symmetrical, in the plasma generating space 4, which allows plasma having a uniformized in-plane density to act on a substrate K.

0045 One embodiment of the present invention has been described above; however, the present invention is not limited thereto and can be implemented in other modes.

0046 For example, although the coil 20 in the above embodiment has six inward projecting portions 21 and five outward projecting portions 22 formed thereon, the numbers of the inward projecting portions 21 and the outward projecting portions 22 are not limited thereto and may be determined as appropriate in accordance with the size of the coil and the like.

0047 Further, although the coil 20 in the above embodiment has a shape in which the inward projecting portions 21 and the outward projecting portions 22 are consecutively formed thereon, the present invention is not limited to this shape and, a coil 50 as shown in Fig. 3 may be employed which has a shape in which three inward projecting portions 51 and two outward projecting portions 52 are formed with spaces between them and the three inward projecting portions 51, and the two outward projecting portions 52 and a gap between two power introducing portions 50a and 50b are alternately arranged at equal intervals along the circumferential direction of the pitch circle P. This configuration also makes it possible to make the plasma density at portions of the plasma generating space 4 corresponding to the inward projecting portions 51 relatively higher and the plasma density at portions corresponding to the outward projecting portions 52 and a portion corresponding to the gap between the power introducing portions 50a and 50b relatively lower, and thereby produce, in the plasma generating space 4, a state where high plasma density portions and low plasma density portions are alternately arranged at equal intervals along the circumferential direction.

0048 Further, in the above embodiment, the coil 20 itself is made compact by forming the coil 20 to have a single turn and making the thickness in the height direction of the coil 20 uniform along the circumferential direction, so that a particularly remarkable effect is achieved in a small-sized plasma etching apparatus 1 which is limited in height, such as a plasma etching apparatus which performs an etching processing on a substrate having a diameter equal to or smaller than 1 inch. However, the coil may have two or more turns in accordance with the size of the apparatus and the like.

0049 Note that, in the case where the coil has two or more turns, the coil can have a transition portion as a singular portion formed thereon, at which, for example, the first wound portion changes to the second wound portion. Further, in the case where the coil has such a transition portion formed thereon, the induced electric field from the transition portion acts on only a part of a portion of the plasma generating space between the first wound portion and the second wound portion, and therefore there is a possibility that the balance of the plasma density in the plasma generating space is easily lost.

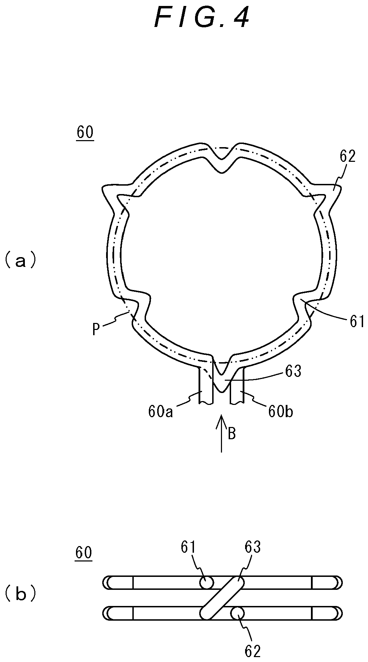

0050 Therefore, in the case where the coil has two or more turns, it is preferred that, as shown in Fig 4, the coil 60 has a transition portion 63 formed thereon near a gap between two power introducing portions 60a and 60b and the transition portion 63 has a shape projecting outward in the radial direction with respect to the pitch circle P. This configuration makes it possible to make the induced electric field from the transition portion acting on a portion of the plasma generating space 4 corresponding to between the wound portions of the coil 60 as weak as possible, which prevents occurrence of a problem that the balance of the plasma density in the plasma generating space 4 is unexpectedly lost.

0051 Further, in the above embodiment, the plasma processing apparatus of the present invention is embodied as a plasma etching apparatus as an example; however, the present invention is not limited thereto and may be embodied as, for example, a plasma CVD apparatus used for forming a thin film on a substrate or a plasma ashing apparatus used for removing a resist.

### Reference Signs List

0052
- 1: Plasma etching apparatus
- 2: Processing chamber
- 3: Processing space
- 4: Plasma generating space
- 5: Lower body portion
- 6: Upper body portion
- 15: Processing gas supply mechanism
- 20: Coil
- 20a, 20b: Power introducing portion
- 21: Inward projecting portion
- 22: Outward projecting portion
- 25: Coil power supply mechanism
- 30: Platen
- 40: Platen power supply mechanism
- 45: Exhaust device
- 50: Coil
- 50a, 50b: Power introducing portion
- 51: Inward projecting portion
- 52: Outward projecting portion
- 60: Coil
- 60a, 60b: Power introducing portion
- 61: Inward projecting portion
- 62: Outward projecting portion
- 63: Transition portion

## Claims

1. A plasma processing apparatus configured to supply a processing gas into a plasma generating space defined in a processing chamber, generate plasma from the processing gas in the plasma generating space by supplying RF power from a coil power supply mechanism to an annular coil wound outside a portion of the processing chamber corresponding to the plasma generating space, and perform a plasma processing on a substrate placed on a platen by the plasma generated from the processing gas, **characterized in that**
the coil has
two power introducing portions having a gap between them, one of the power introducing portions being connected to the coil power supply mechanism and the other being connected to an earth, and
at least three inward projecting portions projecting inward in a radial direction with respect to a reference circle defined around the processing chamber corresponding to the plasma generating space, and
the at least three inward projecting portions are formed at equal intervals along a circumferential direction of the reference circle.

2. The plasma processing apparatus according to claim 1, **characterized in that**
the coil has at least two outward projecting portions formed thereon along the circumferential direction of the reference circle, the outward projecting portions projecting outward in the radial direction with respect to the reference circle, and
the at least two outward projecting portions, the at least three inward projecting portions, and the gap between the power introducing portions are arranged at equal intervals along the circumferential direction.

3. The plasma processing apparatus according to claim 1 or 2, **characterized in that**
the coil has two or more turns and has a transition portion from a wound portion to a next wound portion formed thereon near the gap between the power introducing portions, and
the transition portion projects outward in the radial direction with respect to the reference circle.

4. A plasma processing apparatus configured to supply a processing gas into a plasma generating space defined in a processing chamber, generate plasma from the processing gas in the plasma generating space by supplying RF power from a coil power supply mechanism to an annular coil wound outside a portion of the processing chamber corresponding to the plasma generating space, and perform a plasma processing on a substrate placed on a platen by the plasma generated from the processing gas, **characterized in that**
the coil has
two power introducing portions having a gap between them, one of the power introducing portions being connected to the coil power supply mechanism and the other being connected to an earth, and
at least three inward projecting portions projecting in a direction toward the plasma generating space, and
the at least three inward projecting portions are symmetrically formed at an equal distance and an equal angle with respect to a center of the plasma generating space.

5. The plasma processing apparatus according to claim 4, **characterized in that**
the coil has at least two outward projecting portions formed thereon at an equal distance from the center of the plasma generating space, the outward projecting portions projecting in a direction away from the plasma generating space, and
the at least two outward projecting portions, the at least three inward projecting portions, and the gap between the power introducing portions are symmetrically formed at an equal angle with respect to the center of the plasma generating space.

6. The plasma processing apparatus according to claim 4 or 5, **characterized in that**
the coil has two or more turns and has a transition portion from a wound portion to a next wound portion formed thereon near the gap between the power introducing portions, and
the transition portion projects in a direction away from the plasma generating space.

7. An annular coil used in a plasma processing apparatus configured to generate plasma from a processing gas in a plasma generating space defined in a processing chamber and perform a plasma processing on a substrate by the plasma generated from the processing gas, **characterized by**
having two power introducing portions having a gap between them, and
having at least three inward projecting portions formed thereon at equal intervals along a circumferential direction of a reference circle defined around the processing chamber corresponding to the plasma generating space, the inward projecting portions projecting inward in a radial direction with respect to the reference circle.

8. The coil according to claim 7, **characterized in that**
the coil has at least two outward projecting portions formed thereon along the circumferential direction of the reference circle, the outward projecting portions projecting outward in the radial direction with respect to the reference circle, and
the at least two outward projecting portions, the at least three inward projecting portions, and the gap between the power introducing portions are arranged at equal intervals along the circumferential direction.

9. The coil according to claim 7 or 8, **characterized in that**
the coil has two or more turns and has a transition portion from a wound portion to a next wound portion formed thereon near the gap between the power introducing portions, and
the transition portion projects outward in the radial direction with respect to the reference circle.

10. An annular coil used in a plasma processing apparatus configured to generate plasma from a processing gas in a plasma generating space defined in a processing chamber and perform a plasma processing on a substrate by the plasma generated from the processing gas, **characterized by**
having two power introducing portions having a gap between them, and
having at least three inward projecting portions symmetrically formed thereon at an equal distance and an equal angle with respect to a center of the plasma generating space, the inward projecting portions projecting in a direction toward the plasma generating space.

11. The coil according to claim 10, **characterized in that**
the coil has at least two outward projecting portions formed thereon at an equal distance from the center of the plasma generating space, the outward projecting portions projecting in a direction away from the plasma generating space, and
the at least two outward projecting portions, the at least three inward projecting portions, and the gap between the power introducing portions are symmetrically formed at an equal angle with respect to the center of the plasma generating space.

12. The coil according to claim 10 or 11, **characterized in that**
the coil has two or more turns and has a transition portion from a wound portion to a next wound portion formed thereon near the gap between the power introducing portions, and
the transition portion projects in a direction away from the plasma generating space.
